# EUROPEAN PATENT APPLICATION

(11) **EP 4 750 257 A1**
(43) Date of publication of application: **27.05.2026**
(21) Application number: 25216837.2
(22) Date of filing: 19.11.2025
(51) Int. Cl.: H10D 62/00, H10D 30/67, H10P 14/20

(54) **METHOD FOR MANUFACTURING SEMICONDUCTOR THIN FILM COMPRISING TELLURIUM OXIDE ALLOYED WITH SULFUR ATOM AND HETERO ATOM**

(30) Priority: 25.11.2024 KR 20240169869; 10.11.2025 KR 20250168066
(71) Applicant: POSTECH Research and Business Development Foundation, Pohang-si, Gyeongsangbuk-do 37673 (KR)
(72) Inventor: NOH, Yong Young, 37673 Pohang-si, Gyeongsangbuk-do (KR); CHOI, Ha-Min, 37673 Pohang-si, Gyeongsangbuk-do (KR)
(74) Representative: Jung, Minkyu

(57) **Abstract**

Disclosed is a method for manufacturing semiconductor thin film comprising tellurium oxide alloyed with sulfur atom and hetero atom. According to the present disclosure, by using a sulfur atom and controlling the annealing of the semiconductor thin film, a thin film transistor can be provided that comprises a semiconductor thin film exhibiting excellent output and transfer characteristics and superior electrical performance, with a high hole field-effect mobility and a high on/off current ratio of about 10⁷.

## Description

### [CROSS REFERENCE TO RELATED APPLICATION]

The present application claims the benefit of priority to Korean Patent Application No. 10-2024-0169869 filed on November 25, 2024, and Korean Patent Application No. 10-2025-0168066 filed on November 10, 2025, in the Korean Intellectual Property Office. The aforementioned applications are hereby incorporated by reference in their entireties.

### [TECHNICAL FIELD]

The present disclosure relates to method for manufacturing semiconductor thin film comprising tellurium oxide alloyed with sulfur atom and hetero atom.

### [BACKGROUND ART]

Over the past several decades, metal oxide semiconductors have promoted significant advances in modern optoelectronic research and have been widely used in transistors, photovoltaic cells, thermoelectrics, light-emitting diodes, and displays. However, all commercially available oxide semiconductors with high electrical performance are n-type semiconductors that only exhibit efficient electron transport at room temperature, and there is absence of p-type semiconductors capable of hole transport, limiting their application to various fields. The representative n-type semiconductor, amorphous a-InGaZnO, has been commercialized as a backplane transistor driving organic light-emitting diode (OLED) displays. Its high dispersion conduction band minimum (CBM) allows for excellent electron transport properties even in an amorphous structure, but it has a drawback of not exhibiting p-type characteristics at room temperature.

Materials such as CuₓO and SnO have been studied as p-type metal oxide semiconductors capable of hole transport at room temperature, but they have shown poor electrical performance compared to n-type metal oxides, including lower hole field-effect mobility and lower on/off current ratios. This has significantly limited the development of optoelectronics based on pn junction diodes and complementary metal oxide semiconductor (CMOS) circuits.

The main reason for the poor p-type characteristics of metal oxide semiconductors is that the Valence Band Maximum for hole transport in metal oxides is mainly anisotropic and relatively small in size, consisting of highly localized oxygen 2p orbitals. In addition, the metastable cationic valence states of Cu⁺ and Sn²⁺ are unstable under ambient conditions, which results in poor surrounding stability.

Therefore, the development of stable, low-cost, and highly mobile p-type semiconductor is currently necessary in the microelectronics industry.

### [DISCLOSURE]

### [TECHNICAL PROBLEM]

The purpose of the present disclosure is to solve the aforementioned problems by providing a method for preparing a novel amorphous p-type semiconductor of TeOₓ alloyed with heteroatoms using sulfur, employing vacuum deposition techniques such as thermal evaporation or sputtering.

In addition, another purpose of the present disclosure is to provide a method for preparing a high-performance p-channel TeOₓ semiconductor thin film in which the hole charge of the p-type semiconductor can be precisely controlled using sulfur, and excellent thin film and device electrical properties, stability, and high performance are achieved at a low process temperature.

In addition, another purpose of the present disclosure is to provide a method for preparing a semiconductor thin film that can be used in the manufacturing process of large-area, flexible thin-film transistor at low-cost.

### [TECHNICAL SOLUTION]

One aspect of the present disclosure provides a method for preparing a semiconductor thin film having a tellurium oxide, the method comprising:
(a) preparing a first semiconductor thin film comprising a first semiconductor formed by depositing at least one target selected from the group consisting of a target comprising a Group 14 atom, a target comprising a Group 15 atom, a target comprising a Group 16 atom, a target comprising a copper atom (Cu), and a target comprising a zinc atom (Zn) in the periodic table; at least one target selected from the group consisting of a target comprising a tellurium atom (Te) and a target comprising a tellurium dioxide (TeO₂); and a target comprising a sulfur atom (S); and
(b) annealing the first semiconductor thin film, thus preparing a second semiconductor thin film comprising a second semiconductor.

In addition, the Group 14 atom may comprise at least one selected from the group consisting of a germanium atom (Ge), a tin atom (Sn), and a lead atom (Pb); the Group 15 atom may comprise at least one selected from the group consisting of an antimony atom (Sb), a bismuth atom (Bi), a nitrogen atom (N), and a phosphorus atom (P); and the Group 16 atom may comprise a selenium atom (Se).

In addition, the first semiconductor may comprise: a tellurium composite comprising a tellurium atom (Te) and a tellurium oxide; any one selected from the group consisting of a Group 14 atom, a Group 15 atom, a Group 16 atom, a copper atom (Cu), a zinc atom (Zn), and combinations thereof, alloyed with the tellurium composite; and a sulfur oxide (SOₓ, x is 2 or 3) mixed with the tellurium composite.

In addition, the deposition of step (a) may be carried out at a temperature in a range of room temperature to 70°C.

In addition, the first semiconductor may be represented by Chemical Formula 1:

[Chemical Formula 1] TeOₓ:M₁M₂

wherein in Chemical Formula 1, M₁ is any one selected from the group consisting of a Group 14 atom, a Group 15 atom, a Group 16 atom, a copper atom (Cu), a zinc atom (Zn), and combinations thereof; M₂ is a sulfur atom; and x is in a range of 0 < x < 2.

In addition, the concentration of M₁ in the first semiconductor may be in a range of 1 to 50 atom % based on the total number of atoms.

In addition, the concentration of M₂ in the first semiconductor may be in a range of 1 to 20 atom % based on the total number of atoms.

In addition, the annealing of step (b) may be carried out at a temperature in a range of 100 to 300°C, preferably 150 to 200 °C.

In addition, the second semiconductor may be represented by Chemical Formula 2:

[Chemical Formula 2] TeOₓ:M'₁M'₂

wherein in Chemical Formula 2, M'₁ is any one selected from the group consisting of a Group 14 atom, a Group 15 atom, a Group 16 atom, a copper atom (Cu), a zinc atom (Zn), and combinations thereof; M'₂ is a sulfur atom; and x is in a range of 0 < x < 2.

In addition, the second semiconductor may comprise: a tellurium composite comprising a tellurium atom (Te) and a tellurium oxide; and a heteroatom selected from the group consisting of a germanium atom (Ge), an antimony atom (Sb), a selenium atom (Se), a copper atom (Cu), a zinc atom (Zn), and combinations thereof, alloyed with the tellurium composite.

In addition, the ratio (S_{atom %}:E_{atom %}) of the atom % of sulfur (S_{atom %}) of the second semiconductor and the atom % (E_{atom %}) of the heteroatom of the second semiconductor may be in a range of 5:2 to 5:7, preferably 5:3 to 5:5.

In addition, the tellurium oxide of the second semiconductor may comprise a tellurium monoxide (TeO) and a tellurium dioxide (TeO₂).

In addition, the tellurium atom of the second semiconductor may comprise an ionization state of Te⁴⁺, an ionization state of Te²⁺, and a non-ionization state of Te⁰.

In addition, the second semiconductor may be in an oxygen-deficient state.

In addition, the second semiconductor may be amorphous, polycrystalline, or single crystalline.

In addition, the second semiconductor may be p-type.

In addition, during the annealing of step (b), a sulfur atom of the first semiconductor may be oxidized to a sulfur oxide, thereby increasing an oxygen vacancy by reducing a tellurium oxide of the second semiconductor.

In addition, the conduction channel of the second semiconductor may increase due to formation of the oxygen vacancy.

In addition, the second semiconductor may be for use in a semiconductor layer of a thin film transistor.

In addition, the second semiconductor thin film may have a thickness in a range of 5 to 40 nm.

In addition, the method for preparing the semiconductor thin film may further comprise, between steps (a) and (b):
(b') annealing the first semiconductor thin film at a temperature lower than, equal to, or higher than the annealing temperature of step (b), thereby forming a second' semiconductor thin film, wherein the first semiconductor thin film of step (b) may be the second' semiconductor thin film.

In addition, the annealing of step (b') may be carried out at a temperature in a range of 150 to 200 °C.

In addition, the deposition of step (a) may be carried out by thermal evaporation, sputtering, chemical vapor deposition (CVD), atomic layer deposition (ALD), or solution coating.

### [ADVANTAGEOUS EFFECT]

The thin film transistor (TFT) fabricated by using the method for preparing a TeOₓ channel layer according to the present disclosure exhibits excellent output/transfer characteristics and superior electrical performance with a high hole field-effect mobility and a high on/off current ratio of about 10⁷.

In addition, according to the present disclosure, when sulfur is doped together with a heteroatom such as selenium (Se), the connectivity of oxygen-deficient tellurium (Te) is formed within the TeOₓ thin film, and an alloy between the heteroatom and Te is formed by the heteroatom such as Se included in the thin film, thereby enabling control of the electronic properties of the semiconductor thin film.

### [BRIEF DESCRIPTION OF THE DRAWINGS]

These drawings are for the purpose of describing exemplary embodiments of the present disclosure, and therefore the technical idea of the present disclosure should not be construed as being limited to the accompanying drawings:
FIG. **1** is a schematic diagram illustrating a method for preparing a semiconductor layer using a thermal evaporation process according to an embodiment of the present disclose, in which a tellurium oxide including a sulfur atom and a heteroatom is used in a p-channel thin film transistor (TFT).
FIG. **2** is a graph showing the change in the transfer characteristics of the transistor of the present disclosure according to the type of the heteroatom and the doping concentration.
FIG. **3** is the results of the X-ray photoelectron spectroscopy (XPS) analysis showing that heteroatoms remain in the thin film formed by incorporating the heteroatoms according to the present disclosure.
FIG. **4** is a graph showing the X-ray diffractometer (XRD) spectrum results of a TeOₓ:Se:S thin film prepared by thermal evaporation and annealed at 180°C in Example 3-2.
FIG. **5**A is a graph showing transfer characteristics of a TeOₓ:Se:S TFT prepared by thermal evaporation according to Example 3-2.

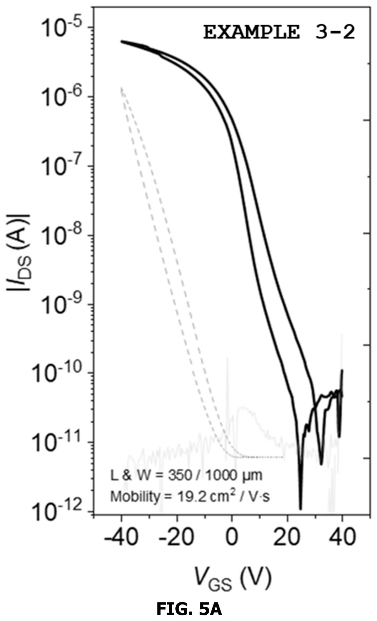

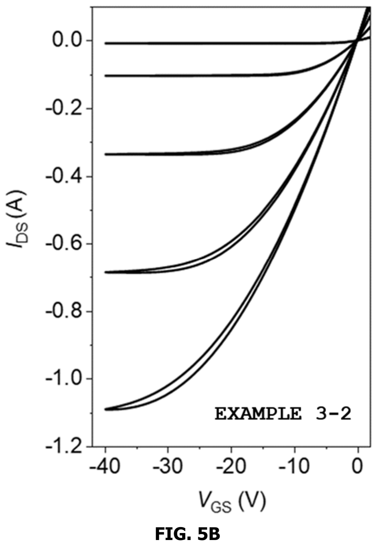

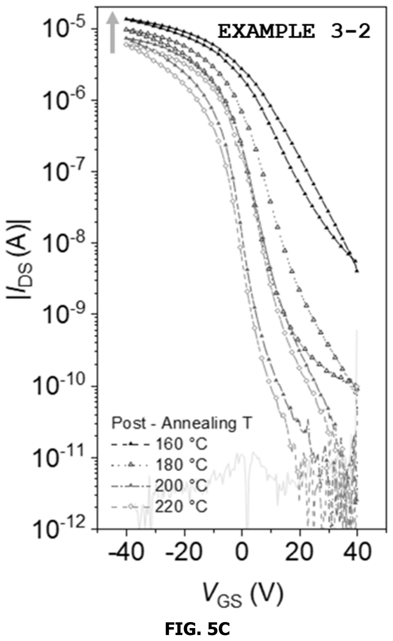

FIG. **5**B is a graph showing the output curves of a TeOₓ:Se:S thin film transistor (TFT) prepared by thermal evaporation according to Example 3-2.
FIG. **5**C is a graph showing the transfer curves of a TeOₓ:Se:S thin film transistor (TFT) prepared with a channel thickness of 25 nm deposited at different post-annealing temperatures using a thermal evaporation process according to Example 3-2.

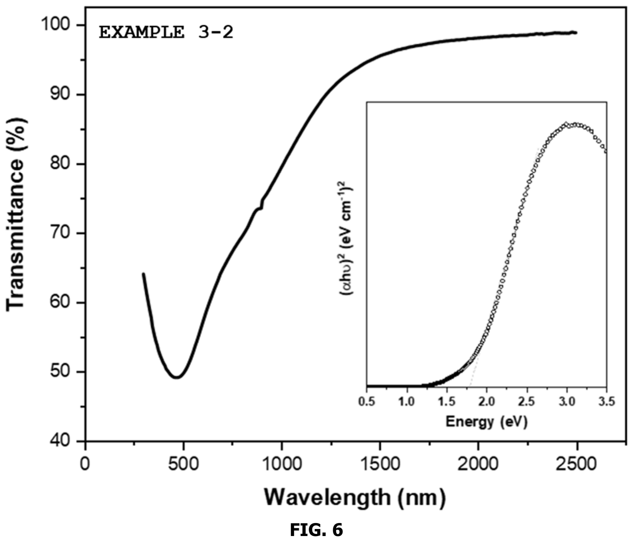

FIG. **6** is a graph showing the absorbance as a function of light wavelength measured by ultraviolet-visible spectroscopy (UV-Vis) and an optical bandgap calculated by a Tauc plot in Example 3-2.

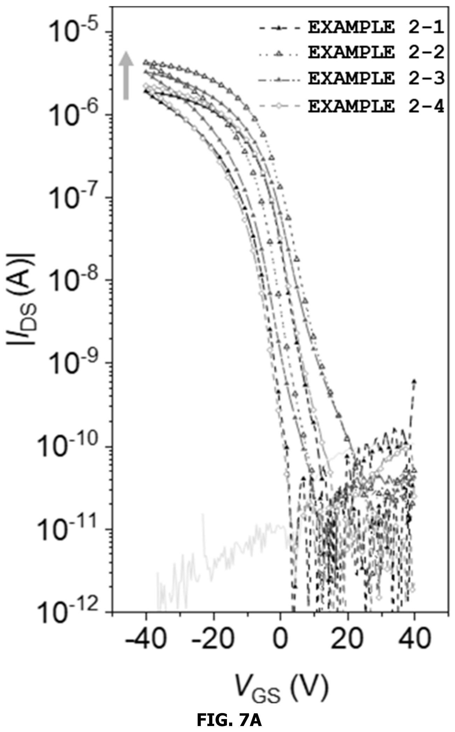

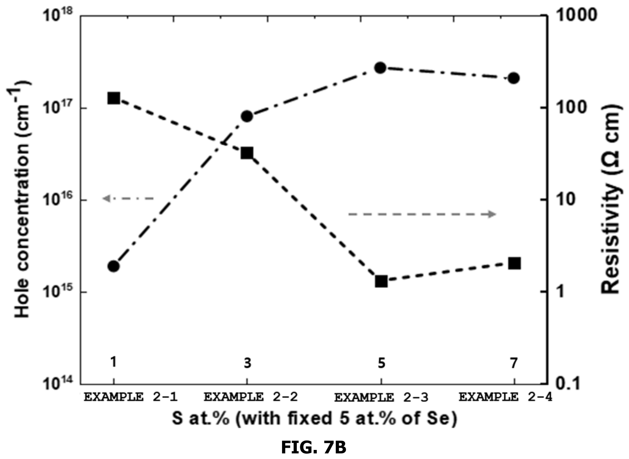

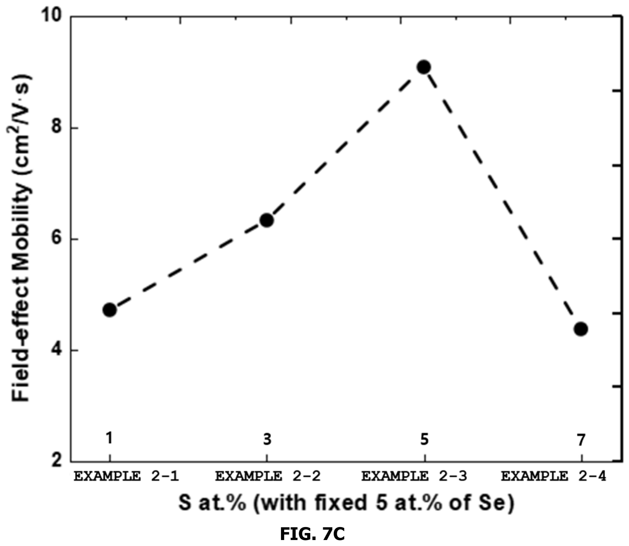

FIG. **7**A is a graph showing the transfer characteristics of TeOₓ:Se:S TFTs according to Examples 2-1, 2-2, 2-3, and 2-4, in which 1, 3, 5, and 7 atom % of sulfur (S) atoms are doped into a tellurium oxide including 5 atom % of a heteroatom selenium (Se).
FIG. **7**B is a graph showing the hole concentration and resistivity of TeOₓ:Se:S TFTs according to Examples 2-1, 2-2, 2-3, and 2-4, in which 1, 3, 5, and 7 atom % of sulfur (S) atoms are doped into a tellurium oxide including 5 atom % of a heteroatom selenium (Se).
FIG. **7**C is a graph showing the field-effect mobility of TeOₓ:Se:S TFTs according to Examples 2-1, 2-2, 2-3, and 2-4, in which 1, 3, 5, and 7 atom % of sulfur (S) atoms are doped into a tellurium oxide including 5 atom % of a heteroatom selenium (Se).

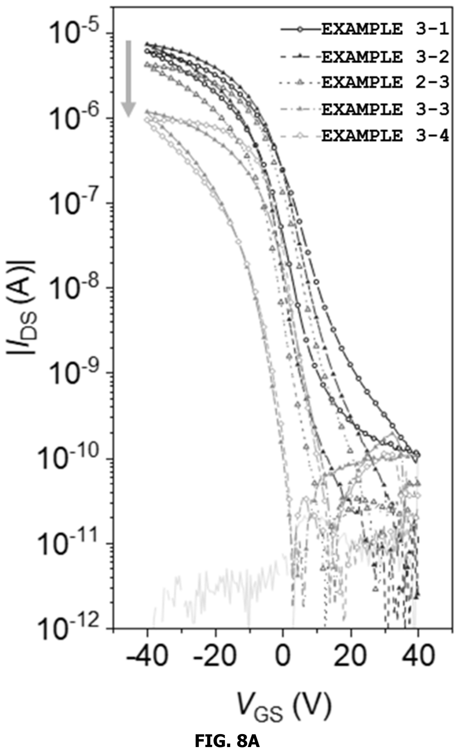

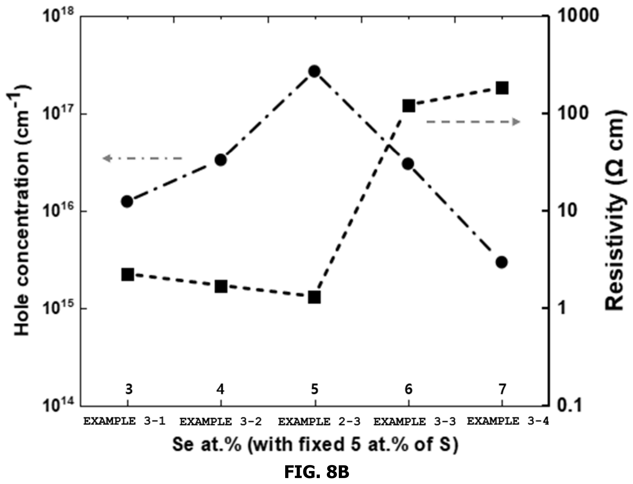

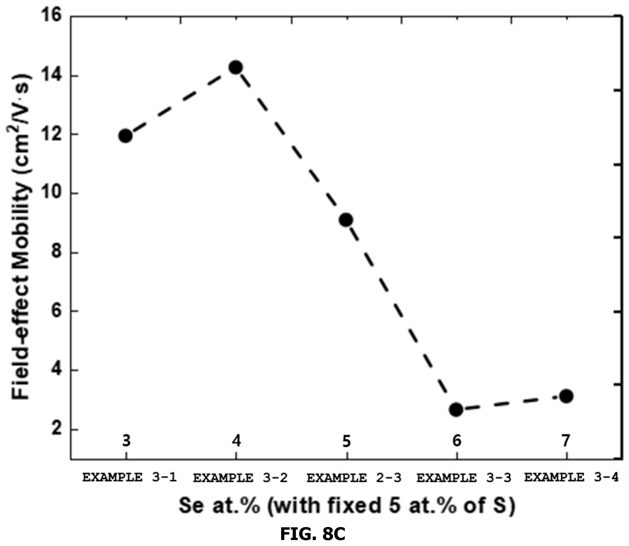

FIG. **8**A is a graph showing the transfer characteristics of TeOₓ:Se:S TFTs according to Examples 3-1, 3-2, 2-3, 3-3, and 3-4, in which 3, 4, 5, 6, and 7 atom % of selenium (Se) atoms are doped into a tellurium oxide including 5 atom % of sulfur (S).
FIG. **8**B is a graph showing the hole concentration and resistivity of TeOₓ:Se:S TFTs according to Examples 3-1, 3-2, 2-3, 3-3, and 3-4, in which 3, 4, 5, 6, and 7 atom % of selenium (Se) atoms are doped into a tellurium oxide including 5 atom % of sulfur (S).
FIG. **8**C is a graph showing the field-effect mobility of TeOₓ:Se:S TFTs according to Examples 3-1, 3-2, 2-3, 3-3, and 3-4, in which 3, 4, 5, 6, and 7 atom % of selenium (Se) atoms are doped into a tellurium oxide including 5 atom % of sulfur (S).

### [DESCRIPTION OF THE PREFERRED EMBODIMENTS]

Herein after, embodiments of the present disclosure will be described in detail with reference to the accompanying drawings in such a manner that the ordinarily skilled in the art can easily implement the embodiments of the present disclosure.

The description given below is not intended to limit the present disclosure to specific Examples. In relation to describing the present disclosure, when the detailed description of the relevant known technology is determined to unnecessarily obscure the gist of the present disclosure, the detailed description may be omitted.

The terminology used herein is for the purpose of describing particular examples only and is not intended to limit the scope of the present disclosure. As used herein, the singular forms "a", "an", and "the" are intended to comprise the plural forms as well unless the context clearly indicates otherwise. It will be further understood that the terms "comprise" or "have" when used in the present disclosure specify the presence of stated features, integers, steps, operations, elements and/or combinations thereof, but do not preclude the presence or addition of one or more other features, integers, steps, operations, elements, and/or combinations thereof.

Terms comprising ordinal numbers used in the specification, "first", "second", etc. can be used to discriminate one component from another component, but the order or priority of the components is not limited by the terms unless specifically stated. These terms are used only for the purpose of distinguishing a component from another component. For example, without departing from the scope of the present disclosure, a first component may be referred as a second component, and a second component may be also referred to as a first component.

In addition, when it is mentioned that a component is "formed" or "stacked" on another component, it should be understood such that one component may be directly attached to or directly stacked on the front surface or one surface of the other component, or an additional component may be disposed between them.

Hereinafter, a method for manufacturing semiconductor thin film comprising tellurium oxide alloyed with sulfur atom and hetero atom will be described in detail. However, those are described as examples, and the present disclosure is not limited thereto and is only defined by the scope of the appended claims.

One aspect of the present disclosure provides a method for preparing a semiconductor thin film having a tellurium oxide, the method comprising:
(a) preparing a first semiconductor thin film comprising a first semiconductor formed by depositing at least one target selected from the group consisting of a target comprising a Group 14 atom, a target comprising a Group 15 atom, a target comprising a Group 16 atom, a target comprising a copper atom (Cu), and a target comprising a zinc atom (Zn) in the periodic table; at least one target selected from the group consisting of a target comprising a tellurium atom (Te) and a target comprising a tellurium dioxide (TeO₂); and a target comprising a sulfur atom (S); and
(b) annealing the first semiconductor thin film, thus preparing a second semiconductor thin film comprising a second semiconductor.

In addition, the Group 14 atom may comprise at least one selected from the group consisting of a germanium atom (Ge), a tin atom (Sn), and a lead atom (Pb); the Group 15 atom may comprise at least one selected from the group consisting of an antimony atom (Sb), a bismuth atom (Bi), a nitrogen atom (N), and a phosphorus atom (P); and the Group 16 atom may comprise a selenium atom (Se).

In addition, the first semiconductor may comprise: a tellurium composite comprising a tellurium atom (Te) and a tellurium oxide; any one selected from the group consisting of a Group 14 atom, a Group 15 atom, a Group 16 atom, a copper atom (Cu), a zinc atom (Zn), and combinations thereof, alloyed with the tellurium composite; and a sulfur oxide (SOₓ, x is 2 or 3) mixed with the tellurium composite.

In addition, the deposition of step (a) may be carried out at a temperature in a range of room temperature to 70 °C. When the deposition temperature is lower than room temperature, surface diffusion of deposited atoms or molecules is suppressed, making it difficult to form a uniform thin film, which is undesirable. When the deposition temperature exceeds 70 °C, re-evaporation of deposited particles or thermal stress-induced damage to the substrate may occur, which is undesirable.

In addition, the first semiconductor may be represented by Chemical Formula 1:

[Chemical Formula 1] TeOₓ: M₁M₂

wherein in Chemical Formula 1, M₁ is any one selected from the group consisting of a Group 14 atom, a Group 15 atom, a Group 16 atom, a copper atom (Cu), a zinc atom (Zn), and combinations thereof; M₂ is a sulfur atom; and x is in a range of 0 < x < 2.

In addition, the concentration of M₁ in the first semiconductor may be in a range of 1 to 50 atom % based on the total number of atoms.

In addition, the concentration of M₂ in the first semiconductor may be in a range of 1 to 20 atom % based on the total number of atoms.

In addition, the annealing of step (b) may be carried out at a temperature in a range of 100 to 300 °C, preferably 150 to 200 °C. When the annealing temperature is lower than 100 °C, sufficient thermal energy for volatilization of sulfur oxide and formation of a tellurium-based conduction channel cannot be supplied, which is undesirable. When the annealing temperature exceeds 300°C, oxidation or volatilization of the thin film may occur, changing the electrical properties, which is undesirable.

In addition, the second semiconductor may be represented by Chemical Formula 2:

[Chemical Formula 2] TeOₓ: M'₁M'₂

wherein in Chemical Formula 2, M'₁ is any one selected from the group consisting of a Group 14 atom, a Group 15 atom, a Group 16 atom, a copper atom (Cu), a zinc atom (Zn), and combinations thereof; M'₂ is a sulfur atom; and x is in a range of 0 < x < 2.

In addition, the second semiconductor may comprise: a tellurium composite comprising a tellurium atom (Te) and a tellurium oxide; and a heteroatom selected from the group consisting of a germanium atom (Ge), an antimony atom (Sb), a selenium atom (Se), a copper atom (Cu), a zinc atom (Zn), and combinations thereof, alloyed with the tellurium composite.

In addition, the ratio (S_{atom %}:E_{atom %}) of the atom % of sulfur (S_{atom %}) of the second semiconductor and the atom % (E_{atom %}) of the heteroatom of the second semiconductor may be in a range of 5:2 to 5:7, preferably 5:3 to 5:5. When the ratio is less than 5:2, the doping amount of the heteroatom is insufficient to exhibit a doping effect, which is undesirable. When the ratio exceeds 5:7, the tellurium oxide-based conduction channel matrix for the p-type semiconductor may not fully function, which is undesirable.

In addition, the tellurium oxide of the second semiconductor may comprise a tellurium monoxide (TeO) and a tellurium dioxide (TeO₂).

In addition, the tellurium atom of the second semiconductor may comprise an ionization state of Te⁴⁺, an ionization state of Te²⁺, and a non-ionization state of Te⁰.

In addition, the second semiconductor may be in an oxygen-deficient state.

In addition, the second semiconductor may be amorphous, polycrystalline, or single crystalline.

In addition, the second semiconductor may be p-type.

In addition, during the annealing of step (b), a sulfur atom of the first semiconductor may be oxidized to a sulfur oxide, thereby increasing an oxygen vacancy by reducing a tellurium oxide of the second semiconductor.

In addition, the conduction channel of the second semiconductor may increase due to formation of the oxygen vacancy.

In addition, the second semiconductor may be for use in a semiconductor layer of a thin film transistor.

In addition, the second semiconductor thin film may have a thickness in a range of 5 to 40 nm.

In addition, the method for preparing the semiconductor thin film may further comprise, between steps (a) and (b):
(b') annealing the first semiconductor thin film at a temperature lower than, equal to, or higher than the annealing temperature of step (b), thereby forming a second' semiconductor thin film, wherein the first semiconductor thin film of step (b) may be the second' semiconductor thin film.

In addition, the annealing of step (b') may be carried out at a temperature in a range of 150 to 200 °C. When the annealing temperature is lower than 150 °C, the thin film cannot have sufficient charge, which is undesirable. When the annealing temperature exceeds 200 °C, volatilization of sulfur oxide increases, causing a rapid increase in charge, making charge control difficult, which is undesirable.

In addition, the deposition of step (a) may be carried out by thermal evaporation, sputtering, chemical vapor deposition (CVD), atomic layer deposition (ALD), or solution coating.

### [EXAMPLES]

Hereinafter, the examples of the present disclosure will be described. However, the examples are for illustrative purposes, and the scope of the present disclosure is not limited by the examples.

### Example: p-channel tellurium oxide thin film transistor

### Example 1: Control of heteroatom type and doping concentration

### Example 1-1: Using 6 mg of antimony (Sb) and 5 mg of sulfur (S)

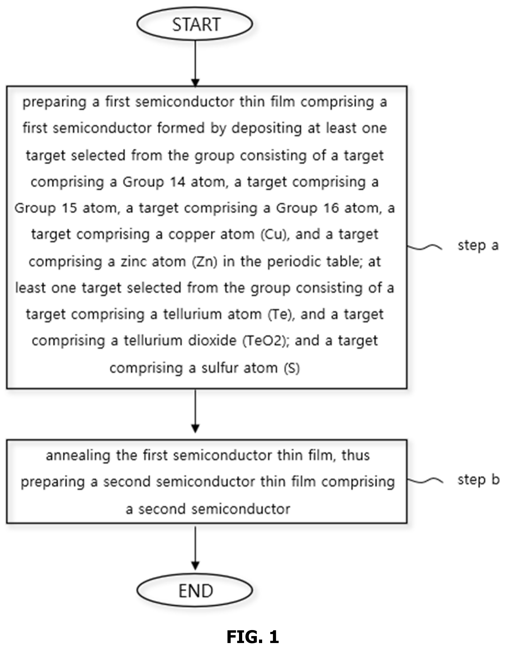

FIG. **1** is a schematic diagram illustrating a method for preparing a semiconductor layer using a thermal evaporation process according to an embodiment of the present disclose, in which a tellurium oxide doped with a sulfur atom and a heteroatom is used in a p-channel thin film transistor (TFT).

Referring to FIG. **1****,** in order to deposit a tellurium oxide-based semiconductor film comprising a sulfur atom and a heteroatom, commercially available 400 mg of TeO₂ powder (purity ≥ 99.995%), 6 mg of antimony (Sb), and 5 mg of sulfur (S) were used as evaporation sources. The TeOₓ-based film was deposited using a conventional thermal evaporator. The substrate temperature was 25 °C, and the vacuum pressure before evaporation was less than 10⁻³ Torr. The distance between the substrate and the boat loaded with TeO₂ was 2 to 50 cm. The deposition rate was 1 Å/s. The thickness of the TeOₓ film (5 to 40 nm) was monitored during the deposition process. The deposited sample was annealed in air at 180°C for 30 minutes to form a TeOₓ:Sb:S tellurium oxide semiconductor thin film.

After that, source/drain electrodes were deposited using Ni to fabricate a thin film transistor (TFT). An aluminum oxide (Al₂O₃) layer with a thickness of about 10 nm was deposited by atomic layer deposition (ALD) at a process temperature of 150 °C to passivate the device from moisture and oxygen.

### Example 1-2: Using 11 mg of antimony (Sb) and 5 mg of sulfur (S)

A thin film transistor (TFT) comprising a TeOₓ:Sb:S tellurium oxide semiconductor was fabricated by the same method as in Example 1-1, except that commercially available 400 mg of TeO₂ powder (purity of 99.995% or higher), 11 mg of antimony (Sb) and 5 mg of sulfur (S) were used as evaporation sources instead of commercially available 400 mg of TeO₂ powder (purity of 99.995% or higher), 6 mg of antimony (Sb) and 5 mg of sulfur (S).

### Example 1-3: Using 6 mg of germanium (Ge) and 5 mg of sulfur (S)

A thin film transistor (TFT) comprising a TeOₓ:Ge:S tellurium oxide semiconductor was fabricated by the same method as in Example 1-1, except that commercially available 400 mg of TeO₂ powder (purity of 99.995% or higher), 6 mg of germanium (Ge) and 5 mg of sulfur (S) were used as evaporation sources instead of commercially available 400 mg of TeO₂ powder (purity of 99.995% or higher), 6 mg of antimony (Sb) and 5 mg of sulfur (S).

### Example 1-4: Using 11 mg of germanium (Ge) and 5 mg of sulfur (S)

A thin film transistor (TFT) comprising a TeOₓ:Ge:S tellurium oxide semiconductor was fabricated by the same method as in Example 1-1, except that commercially available 400 mg of TeO₂ powder (purity of 99.995% or higher), 11 mg of germanium (Ge) and 5 mg of sulfur (S) were used as evaporation sources instead of commercially available 400 mg of TeO₂ powder (purity of 99.995% or higher), 6 mg of antimony (Sb) and 5 mg of sulfur (S).

### Example 1-5: Using 6 mg of copper (Cu) and 5 mg of sulfur (S)

A thin film transistor (TFT) comprising a TeOₓ:Cu:S tellurium oxide semiconductor was fabricated by the same method as in Example 1-1, except that commercially available 400 mg of TeO₂ powder (purity of 99.995% or higher), 6 mg of copper (Cu) and 5 mg of sulfur (S) were used as evaporation sources instead of commercially available 400 mg of TeO₂ powder (purity of 99.995% or higher), 6 mg of antimony (Sb) and 5 mg of sulfur (S).

### Example 1-6: Using 11 mg of copper (Cu) and 5 mg of sulfur (S)

A thin film transistor (TFT) comprising a TeOₓ:Cu:S tellurium oxide semiconductor was fabricated by the same method as in Example 1-1, except that commercially available 400 mg of TeO₂ powder (purity of 99.995% or higher), 11 mg of copper (Cu) and 5 mg of sulfur (S) were used as evaporation sources instead of commercially available 400 mg of TeO₂ powder (purity of 99.995% or higher), 6 mg of antimony (Sb) and 5 mg of sulfur (S).

### Example 1-7: Using 6 mg of selenium (Se) and 5 mg of sulfur (S)

A thin film transistor (TFT) comprising a TeOₓ:Se:S tellurium oxide semiconductor was fabricated by the same method as in Example 1-1, except that commercially available 400 mg of TeO₂ powder (purity of 99.995% or higher), 6 mg of selenium (Se) and 5 mg of sulfur (S) were used as evaporation sources instead of commercially available 400 mg of TeO₂ powder (purity of 99.995% or higher), 6 mg of antimony (Sb) and 5 mg of sulfur (S).

### Example 1-8: Using 11 mg of selenium (Se) and 5 mg of sulfur (S)

A thin film transistor (TFT) comprising a TeOₓ:Se:S tellurium oxide semiconductor was fabricated by the same method as in Example 1-1, except that commercially available 400 mg of TeO₂ powder (purity of 99.995% or higher), 11 mg of selenium (Se) and 5 mg of sulfur (S) were used as evaporation sources instead of commercially available 400 mg of TeO₂ powder (purity of 99.995% or higher), 6 mg of antimony (Sb) and 5 mg of sulfur (S).

### Example 2: Control of sulfur concentration with selenium heteroatom introduced

### Example 2-1: 1 atom % S and 5 atom % Se

To deposit a tellurium oxide-based semiconductor film doped with a sulfur atom and a selenium atom, commercially available 400 mg of TeO₂ powder (purity ≥ 99.995%), 10.96 mg of selenium (Se), and 0.87 mg of sulfur (S) were used as evaporation sources. The TeO_{X}-based film was deposited using a conventional thermal evaporator. The substrate temperature was 25°C, and the vacuum pressure before evaporation was less than 10⁻³ Torr. The distance between the substrate and the boat loaded with TeO₂ was 2 to 50 cm. The deposition rate was 1 Å/s. The thickness of the TeO_{X} film (5 to 40 nm) was monitored during the deposition process. The deposited sample was annealed in air at 180°C for 30 minutes to form a TeO_{X}:Se:S tellurium oxide semiconductor thin film having 1 atom % S and 5 atom % Se.

After that, source/drain electrodes were deposited using Ni to fabricate a TFT. An aluminum oxide (Al₂O₃) layer with a thickness of about 10 nm was deposited by ALD at a process temperature of 150°C to passivate the device from moisture and oxygen.

### Example 2-2: 3 atom % S and 5 atom % Se

A thin film transistor (TFT) comprising a TeOₓ:Se:S tellurium oxide semiconductor was fabricated by the same method as in Example 2-1, except that commercially available 400 mg of TeO₂ powder (purity of 99.995% or higher), 11.08 mg of selenium (Se) and 2.62 mg of sulfur (S) were used as evaporation sources instead of commercially available 400 mg of TeO₂ powder (purity of 99.995% or higher), 10.96 mg of selenium (Se) and 0.87 mg of sulfur (S).

### Example 2-3: 5 atom % S and 5 atom % Se

A thin film transistor (TFT) comprising a TeOₓ:Se:S tellurium oxide semiconductor was fabricated by the same method as in Example 2-1, except that commercially available 400 mg of TeO₂ powder (purity of 99.995% or higher), 10.94 mg of selenium (Se) and 4.48 mg of sulfur (S) were used as evaporation sources instead of commercially available 400 mg of TeO₂ powder (purity of 99.995% or higher), 10.96 mg of selenium (Se) and 0.87 mg of sulfur (S).

### Example 2-4: 7 atom % S and 5 atom % Se

A thin film transistor (TFT) comprising a TeOₓ:Se:S tellurium oxide semiconductor was fabricated by the same method as in Example 2-1, except that commercially available 400 mg of TeO₂ powder (purity of 99.995% or higher), 11.09 mg of selenium (Se) and 6.39 mg of sulfur (S) were used as evaporation sources instead of commercially available 400 mg of TeO₂ powder (purity of 99.995% or higher), 10.96 mg of selenium (Se) and 0.87 mg of sulfur (S).

### Example 3: Control of selenium concentration with sulfur introduced

### Example 3-1: 5 atom % S and 3 atom % Se

To deposit a tellurium oxide-based semiconductor film doped with a sulfur atom and a selenium atom, commercially available 400 mg of TeO₂ powder (purity ≥ 99.995%), 6.53 mg of selenium (Se), and 4.45 mg of sulfur (S) were used as evaporation sources. The TeO_{X}-based film was deposited using a conventional thermal evaporator. The substrate temperature was 25 °C, and the vacuum pressure before evaporation was less than 10⁻³ Torr. The distance between the substrate and the boat loaded with TeO₂ was 2 to 50 cm. The deposition rate was 1 Å/s. The thickness of the TeO_{X} film (5 to 40 nm) was monitored during the deposition process. The deposited sample was annealed in air at 180°C for 30 minutes to form a TeOₓ:Se:S tellurium oxide semiconductor thin film having 5 atom % S and 3 atom % Se.

After that, source/drain electrodes were deposited using Ni to fabricate a TFT. An aluminum oxide (Al₂O₃) layer with a thickness of about 10 nm was deposited by ALD at a process temperature of 150°C to passivate the device from moisture and oxygen.

### Example 3-2: 5 atom % S and 4 atom % Se

A thin film transistor (TFT) comprising a TeOₓ:Se:S tellurium oxide semiconductor was fabricated by the same method as in Example 3-1, except that commercially available 400 mg of TeO₂ powder (purity of 99.995% or higher), 8.73 mg of selenium (Se) and 4.43 mg of sulfur (S) were used as evaporation sources instead of commercially available 400 mg of TeO₂ powder (purity of 99.995% or higher), 6.53 mg of selenium (Se) and 4.45 mg of sulfur (S), thereby forming a TeOₓ:Se:S tellurium oxide semiconductor thin film having 5 atom % S and 4 atom % Se.

### Example 3-3: 5 atom % S and 6 atom % Se

A thin film transistor (TFT) comprising a TeOₓ:Se:S tellurium oxide semiconductor was fabricated by the same method as in Example 3-1, except that commercially available 400 mg of TeO₂ powder (purity of 99.995% or higher), 13.33 mg of selenium (Se) and 4.42 mg of sulfur (S) were used as evaporation sources instead of commercially available 400 mg of TeO₂ powder (purity of 99.995% or higher), 6.53 mg of selenium (Se) and 4.45 mg of sulfur (S), thereby forming a TeOₓ:Se:S tellurium oxide semiconductor thin film having 5 atom % S and 6 atom % Se.

### Example 3-4: 5 atom % S and 7 atom % Se

A thin film transistor (TFT) comprising a TeOₓ:Se:S tellurium oxide semiconductor was fabricated by the same method as in Example 3-1, except that commercially available 400 mg of TeO₂ powder (purity of 99.995% or higher), 15.83 mg of selenium (Se) and 4.42 mg of sulfur (S) were used as evaporation sources instead of commercially available 400 mg of TeO₂ powder (purity of 99.995% or higher), 6.53 mg of selenium (Se) and 4.45 mg of sulfur (S), thereby forming a TeOₓ:Se:S tellurium oxide semiconductor thin film having 5 atom % S and 7 atom % Se.

### Comparative Example 1: no heteroatom and sulfur doping

### Comparative Example 1-1: Pristine tellurium oxide

A thin film transistor (TFT) comprising a TeO_{X} tellurium oxide semiconductor was fabricated by the same method as in Example 3-1, except that commercially available 400 mg of TeO₂ powder (purity ≥ 99.995%) was used as the evaporation source instead of using commercially available 400 mg of TeO₂ powder (purity ≥ 99.995%), 6.53 mg of selenium (Se) and 4.45 mg of sulfur (S).

Table 1 below summarizes the fabrication conditions of the Examples and Comparative Example, including the atom % of sulfur (S) and heteroatoms.

**[Table 1]**

| Example | TeO₂ source (mg) | S source (mg) | Heteroatom source (mg) | | S:Heteroatom (atom%:atom%) |
|---|---|---|---|---|---|
| Example 1-1 | 400 | 5 | Sb | 6 | 5.7:1.8 |
| Example 1-2 | 400 | 5 | Sb | 11 | 5.7:3.3 |
| Example 1-3 | 400 | 5 | Ge | 6 | 5.7:3.0 |
| Example 1-4 | 400 | 5 | Ge | 11 | 5.5:5.4 |
| Example 1-5 | 400 | 5 | Cu | 6 | 5.7:3.4 |
| Example 1-6 | 400 | 5 | Cu | 11 | 5.5:6.1 |
| Example 1-7 | 400 | 5 | Se | 6 | 5.7:3.4 |
| Example 1-8 | 400 | 5 | Se | 11 | 5.6:5.0 |
| Example 2-1 | 400 | 0.87 | Se | 10.96 | 1:5 |
| Example 2-2 | 400 | 2.62 | Se | 11.08 | 3:5 |
| Example 2-3 | 400 | 4.48 | Se | 10.94 | 5:5 |
| Example 2-4 | 400 | 6.39 | Se | 11.09 | 7:5 |
| Example 3-1 | 400 | 4.45 | Se | 6.53 | 5:3 |
| Example 3-2 | 400 | 4.43 | Se | 8.73 | 5:4 |
| Example 3-3 | 400 | 4.42 | Se | 13.33 | 5:6 |
| Example 3-4 | 400 | 4.42 | Se | 15.83 | 5:7 |
| Comparative Example 1-1 | 400 | - | - | - | - |

### [TEST EXAMPLES]

### Test Example 1: transistor transfer characteristics according to type and concentration of heteroatom

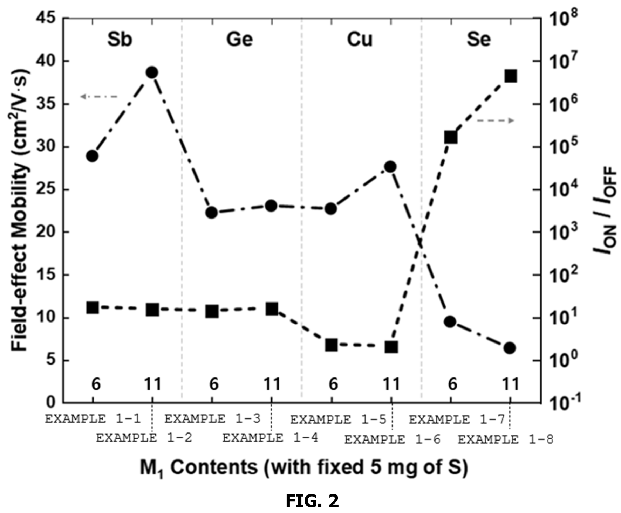

FIG. **2** shows the trend of mobility and on/off current ratio characteristics of thin film transistors according to Examples 1-1 to 1-8, depending on the type and doping concentration of heteroatoms. Referring to FIG. **2****,** in the case of tellurium oxide including sulfur, it can be seen that thin film transistors with high mobility or a large on/off current ratio can be implemented depending on the types and incorporation levels of heteroatoms even at low annealing temperatures 200 °C and below.

### Test Example 2: Confirmation of heteroatom residue in the formed thin film

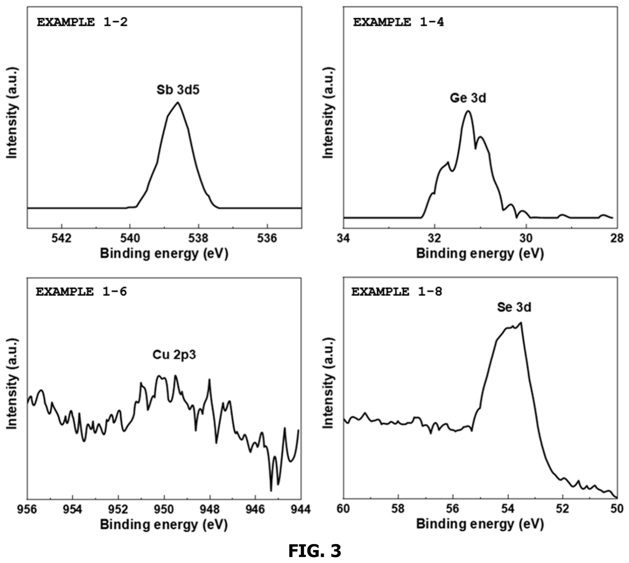

FIG. **3** shows the results of X-ray photoelectron spectroscopy (XPS) analysis of thin films formed according to Examples 1-1 to 1-8, confirming the presence and concentration of heteroatoms remaining in the thin film. Referring to FIG. **3****,** it was confirmed that heteroatoms sufficiently remain in the thin film.

### Test Example 3: Amorphous nature of the thin film

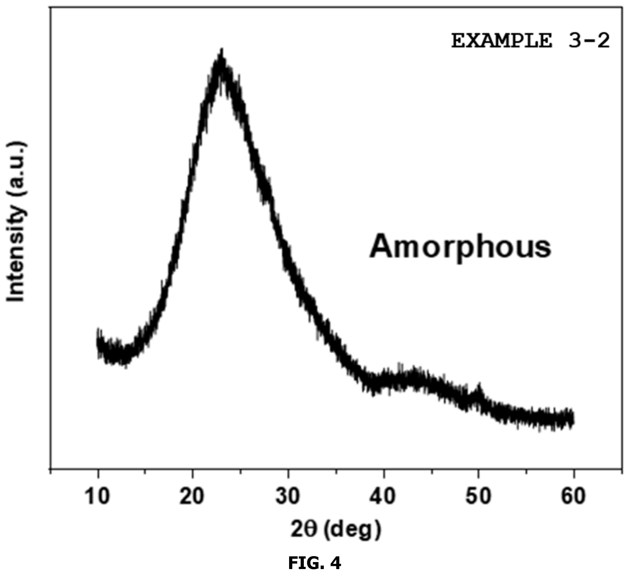

FIG. **4** is a graph showing the X-ray diffractometer (XRD) spectrum results of a TeOx:Se:S thin film prepared by thermal evaporation and annealed at 180°C in Example 3-2. Referring to FIG. **4****,** it was confirmed that the TeO_{X}:Se:S thin film was formed close to an amorphous state on the glass substrate.

### Test Example 4: Transfer characteristics and optical bandgap of TeOₓ:Se:S TFT

FIG. **5**A is a graph showing the transfer curves of a TeO_{X}:Se:S thin film transistor (TFT) measured under optimized conditions (VDS = -0.1 V), the device being fabricated by thermal evaporation according to Example 3-2.
FIG. **5**B is a graph showing the output curves of a TeO_{X}:Se:S TFT fabricated by thermal evaporation according to Example 3-2.
FIG. **6** is a graph showing the absorbance as a function of light wavelength measured by ultraviolet-visible spectroscopy (UV-Vis) and the optical bandgap calculated by a Tauc plot for Example 3-2.

Referring to FIGs. **5**A and **5**B, it can be seen that the field-effect hole mobility (µh) of the TeOₓ:Se:S TFT according to Example 3-2 was 19.2 cm²/V·s, and the on/off current ratio was about 10⁷. Referring to FIG. **6****,** from the x-axis intercept value of the Tauc plot calculation graph, it can be seen that the optical bandgap of the TeO_{X}:Se:S TFT was approximately 1.79 eV.

### Test Example 5: Transfer curve of TeOₓ:Se:S TFT depending on post-annealing temperature

FIG. **5**C is a graph showing the transfer curves of a TeO_{X}:Se:S TFT fabricated with a channel thickness of 25 nm deposited at different post-annealing temperatures using a thermal evaporation process according to Example 3-2.

Referring to FIG. **5**C, it can be seen that as the post-annealing temperature increased, the charge amount increased, and the optimal process temperature was 180 °C.

### Test Example 6: Electrical characteristics of TeOₓ:Se:S TFT depending on the ratio of sulfur (S)

FIGs. **7**A, **7**B, and **7**C are graphs showing the transfer characteristics, the hole concentration and resistivity, and the field-effect mobility, respectively, of TeOₓ:Se:S TFTs according to Examples 2-1, 2-2, 2-3, and 2-4, in which 1, 3, 5, and 7 atom % of sulfur (S) atoms were doped into a tellurium oxide including 5 atom % of heteroatom selenium (Se).

Referring to FIGs. **7**A to **7**C, it was confirmed that when sulfur (S) was doped at 5 atom %, the highest hole mobility was obtained, and when the doping concentration exceeded this, the charge amount decreased.

### Test Example 7: Electrical characteristics of TeOₓ:Se:S TFT according to change in selenium (Se) ratio

FIGs. **8**A, **8**B, and **8**C are graphs showing the transfer characteristics, the hole concentration and resistivity, and the field-effect mobility, respectively, of TeOₓ:Se:S TFTs according to Examples 3-1, 3-2, 2-3, 3-3, and 3-4, in which 3, 4, 5, 6, and 7 atom % of selenium (Se) atoms were doped into a tellurium oxide including 5 atom % of sulfur (S).

Referring to FIGs. **8**A to **8**C, it was confirmed that when selenium (Se) was doped at 4 atom %, the highest hole mobility was obtained, and when the doping concentration exceeded this, the mobility decreased.

The scope of the present disclosure is defined by the following claims rather than the above detailed description, and all changes or modifications derived from the meaning and scope of the claims and their equivalent concepts should be interpreted as falling into the scope of the present disclosure.

## Claims

1. A method for preparing a semiconductor thin film, the method comprising:
(a) preparing a first semiconductor thin film comprising a first semiconductor formed by depositing at least one target selected from the group consisting of a target comprising a Group 14 atom, a target comprising a Group 15 atom, a target comprising a Group 16 atom, a target comprising a copper atom (Cu), and a target comprising a zinc atom (Zn) in the periodic table; at least one target selected from the group consisting of a target comprising a tellurium atom (Te) and a target comprising a tellurium dioxide (TeO₂); and a target comprising a sulfur atom (S); and
(b) annealing the first semiconductor thin film, thus preparing a second semiconductor thin film comprising a second semiconductor.

2. The method of claim 1, wherein the group 14 atom comprises at least one selected from the group consisting of a germanium atom (Ge), a tin atom (Sn), and a lead atom (Pb);
the Group 15 atom comprises at least one selected from the group consisting of an antimony atom (Sb), a bismuth atom (Bi), a nitrogen atom (N), and a phosphorus atom (P); and
the Group 16 atom comprises a selenium atom (Se).

3. The method of claim 1, wherein the first semiconductor comprises:
a tellurium composite comprising a tellurium atom (Te) and a tellurium oxide;
any one selected from the group consisting of a Group 14 atom, a Group 15 atom, a Group 16 atom, a copper atom (Cu), a zinc atom (Zn), and combinations thereof, alloyed with the tellurium composite; and
a sulfur oxide (SOₓ, x is 2 or 3) mixed with the tellurium composite.

4. The method of claim 1, wherein the deposition of step (a) is carried out at a temperature in a range of room temperature to 70°C.

5. The method of claim 1, wherein the first semiconductor is represented by the Chemical Formula 1:
[Chemical Formula 1] TeOₓ:M₁M₂
wherein in Chemical Formula 1,
M₁ is any one selected from the group consisting of a Group 14 atom, a Group 15 atom, a Group 16 atom, a copper atom (Cu), a zinc atom (Zn), and combinations thereof in the periodic table,
M₂ is a sulfur atom, and
x is in a range of 0<x<2.

6. The method of claim 1, wherein the annealing of step (b) is carried out at a temperature in a range of 100 to 300°C.

7. The method of claim 1, wherein the second semiconductor is represented by Chemical Formula 2:
[Chemical Formula 2] TeOₓ: M'₁M'₂
wherein in Chemical Formula 2,
M'₁ is any one selected from the group consisting of a Group 14 atom, a Group 15 atom, a Group 16 atom, a copper atom (Cu), a zinc atom (Zn), and combinations thereof in the periodic table,
M'₂ is a sulfur atom (S), and
x is in a range of 0<x<2.

8. The method of claim 1, wherein the second semiconductor comprises;
a tellurium composite comprising a tellurium atom (Te) and a tellurium oxide; and
a heteroatom selected from the group consisting of a germanium atom (Ge), an antimony atom (Sb), a selenium atom (Se), a copper atom (Cu), a zinc atom (Zn), and combinations thereof, alloyed with the tellurium composite.

9. The method of claim 8, wherein the ratio (S_{atom %}:E_{atom %}) of the atom % of sulfur (S_{atom %}) of the second semiconductor and the atom % (E_{atom %}) of the heteroatom of the second semiconductor is in a range of 5:2 to 5:7.

10. The method of claim 8, wherein the tellurium oxide of the second semiconductor comprises a tellurium monoxide (TeO) and a tellurium dioxide (TeO₂).

11. The method of claim 1, wherein a tellurium atom of the second semiconductor comprises an ionization state of Te⁴⁺, an ionization state of Te²⁺, and a non-ionization state of Te⁰.

12. The method of claim 1, wherein the second semiconductor is in an oxygen-deficient state.

13. The method of claim 1, wherein the second semiconductor is p-type.

14. The method of claim 1, wherein during the annealing of step (b), a sulfur atom of the first semiconductor is oxidized to a sulfur oxide, thereby increasing an oxygen vacancy by reducing a tellurium oxide of the second semiconductor.

15. The method of claim 1, wherein the deposition of step (a) is carried out by thermal evaporation, sputtering, chemical vapor deposition (CVD), atomic layer deposition (ALD), or solution coating.
